# EUROPÄISCHE PATENTSCHRIFT

(11) **EP 3 769 596 B1**
(45) Veröffentlichungstag und Bekanntmachung des Hinweises auf die Patenterteilung: **22.03.2023**
(21) Anmeldenummer: 19728662.8
(22) Anmeldetag: 04.06.2019
(51) Int. Cl.: H05K 7/14

(54) **STEUERUNGSELEKTRONIK IN MODULARER BAUWEISE**
CONTROL ELECTRONICS IN MODULAR DESIGN
ÉLECTRONIQUE DE COMMANDE DE CONCEPTION MODULAIRE

(30) Priorität: 27.07.2018 DE 102018118181
(43) Veröffentlichungstag der Anmeldung: 27.01.2021
(73) Patentinhaber: ebm-papst Mulfingen GmbH & Co. KG, 74673 Mulfingen (DE)
(72) Erfinder: KRANZ, Christian, 97990 Weikersheim (DE); SCHNEIDER, Alex, 74653 Künzelsau (DE); PILS, Malte, 74532 Ilshofen-Oberaspach (DE); BOLLGÖNN, Oliver, 74626 Bretzfeld (DE)
(74) Vertreter: Staeger & Sperling Partnerschaftsgesellschaft mbB
(86) Internationale Anmeldenummer: PCT/EP2019/064411
(87) Internationale Veröffentlichungsnummer: WO 2020/020519

(56) Entgegenhaltungen:
- DE-A1- 10 035 970
- US-A- 5 619 111

## Beschreibung

Die Erfindung betrifft eine Steuerungselektronik in modularer Bauweise.

Im Stand der Technik sind bereits verschiedene modular aufgebaute Steuerelektroniken bekannt. Oft wird dabei auf eine kompakte Bauweise gesetzt, welche den unterschiedlichen Einbaubedingungen und den engen Platzverhältnissen gerecht werden muss. Aus diesem Grund werden funktional zusammengehörige Unterbaugruppen der Gesamtelektronik, wie z.B. Schaltnetzteil, Lüfterkommutierungen, Steuer- und Regelgeräte, auf separate Leiterplatten aufgebaut und in einen Grundträger der Steuerelektronik gesteckt, welcher meist die Leistungselektronik zur Energieversorgung der Unterbaugruppen trägt.

Das hat jedoch den Nachteil, dass an den Unterbaugruppen und dem Grundträger keine einfach zu realisierenden Maßnahmen zur Verbesserung der elektromagnetischen Verträglichkeit (EMV) eingesetzt werden können oder diese keine oder nur eine unzureichende Wirkung haben. Hinzukommt, dass die Leiterplatten ggf. eine jeweils voneinander getrennte Spannungsversorgung benötigen und die in den Grundträger eingesteckten Leiterplatten bzw. die elektronischen Bauelemente der Unterbaugruppen eine erhöhte Vibrations- und Schockempfindlichkeit aufweisen. Vorhandene Bauteile zur Verbesserung der EMV sowie zur Spannungsversorgung sind bei den im Stand der Technik bekannten Steuerungselektroniken oft auf jeder der Leiterplatten der Unterbaugruppen realisiert und somit redundant vorhanden. Desweiteren ist in vielen Fällen eine Kühlanbindung der elektronischen Komponenten der Unterbaugruppen nur unzureichend oder nur unter erhöhten Aufwand realisierbar.

Eine Steuerelektronik in modularer Bauweise ist beispielsweise aus der Schrift US 5 619 111 A bekannt, wobei weitere Aspekte zu einer modular aufgebauten Steuerelektronik der DE 100 35 970 A1 zu entnehmen sind.

Der Erfindung liegt deshalb die Aufgabe zugrunde, eine flexibel aufgebaute Steuerungselektronik bereitzustellen, bei welcher Komponenten zur Spannungserzeugung sowie Komponenten zur Verbesserung der EMV nicht redundant vorhanden sind und zugleich ein einfacher sowie platzsparender Aufbau der Steuerungselektronik möglich ist.

Diese Aufgabe wird durch die Merkmalskombination gemäß Patentanspruch 1 gelöst.

Grundidee der vorliegenden Erfindung ist eine modulare Bauweise, bei der die elektrischen Bauelemente, aus welchen die Steuerungselektronik gebildet ist, nach thermischen Gesichtspunkten sowie nach Gesichtspunkten der EMV in jeweils voneinander getrennten Modulen anzuordnen, so dass es durch die Aufteilung der Bauelemente in die Module sowie die Anordnung und den Aufbau der Module zu einer Verbesserung der EMV kommt, wobei die Module zugleich spezifisch auf die jeweiligen thermischen Anforderungen gekühlt werden können. Ferner kann durch die Anordnung der Module erreicht werden, dass Bauelemente nicht oder nur geringfügig durch die Bauelemente benachbarter Module erhitzt werden.

Erfindungsgemäß wird daher eine Steuerungselektronik in modularer Bauweise vorgeschlagen. Die Steuerungselektronik umfasst ein elektronisches Grundmodul und eine Vielzahl von Funktionsmodulen. Das Grundmodul stellt wenigstens eine Zwischenkreisspannung U_{ZK} an einem Spannungsversorgungsausgang zur Spannungsversorgung der Funktionsmodule bereit. Die Funktionsmodule sind elektrisch und mechanisch mit dem Grundmodul verbunden und von dem Grundmodul mit der Zwischenkreisspannung U_{ZK} versorgt, so dass die Funktionsmodule nicht jeweils eine voneinander separierte Spannungsversorgung benötigen. Das Grundmodul und die Funktionsmodule weisen jeweils einen Träger mit elektronischen Bauelementen auf. Vorzugsweise umfasst der Träger zumindest eine Leiterplatte, wobei die elektronischen Bauelemente auf zumindest einer Seite der Leiterplatte angeordnet und beispielsweise durch in die Leiterplatte eingebettete Leiterbahnen miteinander verbunden sind. Die elektronischen Bauelemente des Grundmoduls erzeugen zur Spannungsversorgung der elektronischen Bauelemente der Funktionsmodule die Zwischenkreisspannung U_{ZK}. An dem Träger des Grundmoduls ist zumindest ein Funktionsmodul befestigt, beispielsweise auch indirekt über einen Abstandshalter. Die elektronischen Bauelemente des Grundmoduls und der Funktionsmodule sind zudem durch eine thermische Entkopplung und/oder eine EMV-Abschirmung voneinander getrennt angeordnet.

Eine vorteilhafte Ausführungsform der Erfindung sieht zudem vor, dass der Träger zumindest eines Funktionsmoduls und/oder der Träger des Grundmoduls jeweils eine Bauelementseite, auf welcher die elektronischen Bauelemente angeordnet sind, und eine Schirmseite aufweisen, auf welcher eine sich über den Träger erstreckende EMV-Abschirmvorrichtung angeordnet ist. Die EMV-Abschirmvorrichtung zur Abschirmung elektromagnetischer Störstrahlen kann beispielsweise als Beschichtung oder Folie ausgebildet sein, welche die Schirmseite des Trägers vorzugsweise vollständig bedeckt. EMV-Abschirmvorrichtungen sind meist aus elektrisch leitfähigem Material gebildet oder umfassen dieses.

Um die Funktionsmodule untereinander und/oder mit dem Grundmodul zu verbinden, sieht eine weitere vorteilhafte Ausgestaltungsvariante der Erfindung vor, dass sich ein Durchsteckverbinder von dem Träger des Grundmoduls zu dem Träger eines Funktionsmoduls oder zwischen den Trägern zweier Funktionsmodule erstreckt.

Zur Verbesserung der Schirmwirkung der Schirmschicht verbindet der Durchsteckverbinder bei einer ebenfalls vorteilhaften Weiterbildung die EMV-Abschirmvorrichtung des Grundmoduls mit der EMV-Abschirmvorrichtung des Funktionsmoduls oder die EMV-Abschirmvorrichtungen der Funktionsmodule elektrisch miteinander.

Wenigstens eine der EMV-Abschirmvorrichtungen ist bei einer Fortbildung der Steuerungselektronik zur Verbesserung der Schirmwirkung zudem mit einem vorbestimmten Potential verbunden.

Die Träger der Funktionsmodule und der Träger des Grundmoduls sind bei einer vorteilhaften Ausführungsvariante der Steuerungselektronik in einer vorbestimmten Anordnung zueinander parallel und jeweils zueinander beabstandet in vorzugsweise vorbestimmten Montageebenen angeordnet, um eine weitere Verbesserung der Schirmwirkung zu erzielen oder bestimmte Bereiche der Funktionsmodule und des Grundmoduls gezielt vor elektromagnetischer Störstrahlung abzuschirmen.

Eine vorteilhafte Weiterbildung sieht vor, dass zwischen den elektronischen Bauelementen des Grundmoduls und den elektronischen Bauelementen eines Funktionsmoduls und/oder zwischen den elektronischen Bauelementen zweier Funktionsmodule jeweils eine der jeweiligen EMV-Abschirmvorrichtungen angeordnet ist. Zwischen den Bauelementseiten zweiter Träger ist somit jeweils eine Schirmseite mit der EMV-Abschirmvorrichtung vorgesehen, wodurch die Bauelemente der zwei Träger zueinander durch die EMV-Abschirmvorrichtung getrennt sind.

Die Träger der Funktionsmodule und der Träger des Grundmoduls bestimmen bei einer vorteilhaften Weiterbildungsalternative in einer vorbestimmten Anordnung einen Aufnahmeraum zwischen sich, der zu jeder Seite durch die Träger der Funktionsmodule und den Träger des Grundmoduls begrenzt ist. Die elektronischen Bauelemente des Grundmoduls und die elektronischen Bauelemente der Funktionsmodule sind dabei in dem Aufnahmeraum angeordnet. Der Aufnahmeraum ist durch die Träger vor elektromagnetischer Strahlung abgeschirmt und bildet einen EMV-Schutzraum, in welchem die Bauelemente angeordnet und vor einer elektromagnetischen Störstrahlung geschützt sind.

Eine vorteilhafte Weiterbildungsvariante der Steuerungselektronik sieht zudem vor, dass der Träger des Grundmoduls und die Träger der Funktionsmodule an dem Distanzhalter fixiert sind und diese durch den Distanzhalter in ihrer vorbestimmten Anordnung zueinander gehalten werden.

Ferner ist das Grundmodul bei einer alternativen Fortbildung der Erfindung integral mit einem Funktionsmodul gemeinsam auf dem Träger des Grundmoduls ausgebildet.

Ebenfalls vorteilhaft ist bei einer Ausbildungsalternative, dass zumindest zwei Funktionsmodule integral miteinander auf einem gemeinsamen Träger ausgebildet sind.

Zumindest ein Teil der Funktionsmodule umfasst bei einer vorteilhaften Variante der Erfindung zudem als elektronische Bauelemente zumindest eine Kommutierungseinheit zur Kommutierung der Zwischenkreisspannung U_{ZK} und einen EMV-Filter. Der EMV-Filter ist hierbei ausgebildet, die kommutierte Spannung zu filtern.

Zur Gruppierung zum Zwecke der sich daraus ergebenden Anordnung der Bauelemente sieht die erfindungsgemäße Steuerungselektronik vor, dass die elektronischen Bauelemente nach ihrer Funktion in Gruppen getrennt sind. Die Gruppen sind nach der Höhe bzw. der Bemessung ihrer elektronischen Leistungsaufnahme oder Leistungsabgabe bewertet. Die Bewertung der Leistungsaufnahme oder Leistungsabgabe bestimmt eine Zuordnung der Bauelemente zu dem Grundmodul und zu den Funktionsmodulen sowie die relative Position der Bauelemente und/oder die relative Position des Grundmoduls und der Funktionsmodule zueinander.

Neben einer Bewertung der Leistungsaufnahme oder Leistungsabgabe kann zudem auch die Anfälligkeit für elektromagnetische Störstrahlung und/oder eine Höhe der von den Bauelementen emittierten elektromagnetischen Störstrahlung bewertet werden, welche die Zuordnung der Bauelemente zu dem Grundmodul und den Funktionsmodulen sowie die Anordnung der Funktionsmodule zueinander und zu dem Grundmodul bestimmen.

Die Bewertung der Leistungsaufnahme oder Leistungsabgabe bestimmt bei erfindungsgemäß einen Abstand zwischen den Funktionsmodulen und einen Abstand des jeweiligen Funktionsmoduls zu dem Grundmodul. Zusätzlich oder alternativ kann die Bewertung eine Ausrichtung und/oder Beabstandung der Funktionsmodule zueinander oder zu dem Grundmodul bestimmen.

An dem Träger des Grundmoduls und/oder an den Trägern der Funktionsmodule sind zudem vorzugsweise Kühlelemente angeordnet.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine erste aus mehreren Funktionsmodulen und einem Grundmodul bestehende Steuerelektronik;
- Fig. 2: eine Anordnung eines Grundmoduls und mehrerer Funktionsmodule einer zweiten Steuerelektronik zueinander;
- Fig. 3: eine Anordnung eines Grundmoduls und mehrerer Funktionsmodule einer dritten Steuerelektronik zueinander.

Die Figuren sind beispielhaft schematisch. Gleiche Bezugszeichen in den Figuren weisen auf gleiche funktionale und/oder strukturelle Merkmale hin.

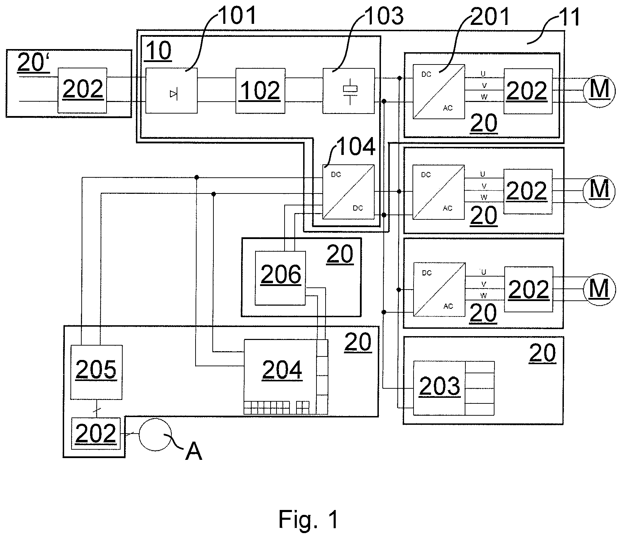

Figur 1 stellt schematisch den modularen Aufbau einer Steuerelektronik da. Die Bauelemente 11, 101, 102, 103, 104, 201, 202, 203, 204, 205, 206 wurden nach ihrer Funktion und ihrer elektromagnetischen Störleistung zu Modulen gruppiert. Dazu wurden alle Bauelemente, welche zur die Erzeugung der Zwischenkreisspannung U_{ZK} dienen dem Grundmodul 10 zugeordnet.

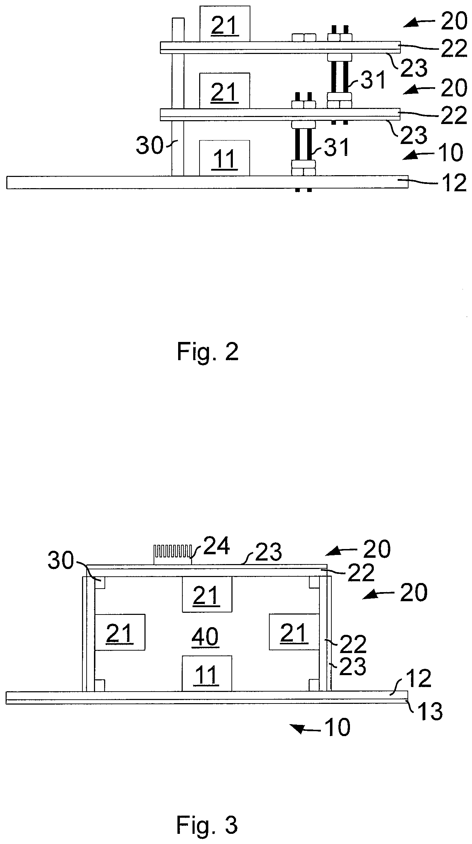

Die Bauelemente zur Erzeugung der Versorgungsspannung aus einer in dem Grundmodul 10 erzeugten Zwischenkreisspannung U_{ZK} und zur Regelung eines Verbrauchers, beispielsweise eines Motors M, sind zu den Funktionsmodulen 20 gruppiert, wobei die Leistungsaufnahme und somit die Temperaturentwicklung der Bauelemente eines Funktionsmoduls 20 jeweils einen vorbestimmten Grenzwert nicht überschreiten. Die Bauelemente können zudem eine elektromagnetische Störstrahlung abgeben, wobei die Bauelemente eines Funktionsmoduls auch einen vorbestimmten Grenzwert der Störstrahlung nicht überschreiten. Die Funktionsmodule 20 werden anhand ihrer Leistungsaufnahme und der von ihnen erzeugten elektromagnetischen Störstrahlung in einer bestimmten Ausrichtung und Anordnung zueinander an dem Grundmodul 10 angeordnet, welche jedoch in Figur 1 nicht gezeigt ist. Die Funktionsmodule 20 können an dem Grundmodul 10 beispielsweise in einer in den Figuren 2 und 3 gezeigten Anordnung fixiert werden.

Das Grundmodul 10 umfasst bei der in Figur 1 gezeigten Ausführungsvariante zur Erzeugung der Zwischenkreisspannung U_{ZK} einen Gleichtrichter 101, ein Spannungsregelbauteil 102 zur Spannungsanpassung mit integrierter EMV-Filterung und einen Zwischenkreiskondensator 103. Zur EMV-Filterung der Eingangsspannung des Grundmoduls 10 ist dem Grundmodul 10 und allen Funktionsmodulen 20 ein Vormodul 20' vorgeschalten, das eingangsseitig mit der Netzspannung und ausgangsseitig mit dem Grundmodul 10 verbunden ist und die Netzspannung durch einen EMV-Filter 202 filtert und die gefilterte Spannung dem Grundmodul 10 bereitstellt. Die Motoren M werden mit einem dreiphasigen UVW-Spannungsanschluss versorgt. Die zugehörigen Funktionsmodule weisen daher einen DC/AC-Wandler 201 mit Kommutierung und zur Filterung der erzeugten Wechselspannung einen EMV-Filter 202 auf. Bei dem dargestellten Ausführungsbeispiel ist der EMV-Filter 202 leitungstechnisch zwischen dem DC/AC-Wandler 201 und dem Motor M angeordnet, so dass die durch den DC/AC-Wandler 201 gewandelte Spannung gefiltert wird. Alternativ kann der EMV-Filter 202 auch leitungstechnisch vor dem DC/AC-Wandler 201 angeordnet sein, so dass der DC/AC-Wandler 201 zwischen dem EMV-Filter 202 und dem Motor M angeordnet ist, wobei dann die Zwischenkreisspannung U_{ZK} gefiltert und anschließend zur Wandlung in den DC/AC-Wandler 201 geleitet wird. Die Leistungsaufnahme der Spannungserzeugung für die Motoren M ist so groß, dass diese jeweils als ein eigenes Funktionsmodul 20 bereitgestellt werden muss. Ferner muss für jeden Motor M ein separates Funktionsmodul 20 bereits gestellt werden, da jeder der Motoren M eigene elektrische Parametergrößen hat, jeder Motor M gemäß einer eigenen (individuellen) Drehzahlkennlinie betrieben wird und die Sollwertvorgaben für jeden Motor M bzw. für jeden durch den jeweiligen Motor M angetriebenen Verbraucher (Lüfter) unterschiedlich sein können. Ein weiteres Funktionsmodul 20 versorgt zusätzliche Komponenten bzw. Bauelemente, wie beispielsweise allgemeine Verbraucher wie ein Relais 203, mit der benötigten Zwischenkreisspannung U_{ZK}. Weitere Funktionsmodule 20, die eine Niederspannung statt der Zwischenkreisspannung U_{ZK} benötigen, können sich ein Niederspannungswandler 104 teilen und von diesem mit der Niederspannung versorgt sein. Der Niederspannungswandler 104 ist hierbei Bestandteil des Grundmoduls 10. Durch die Niederspannung kann beispielsweise ein Funktionsmodul 20 mit einem Display 206 oder ein Funktionsmodul 20 zur Regelung eines Kältekreislaufs versorgt sein. Bei dem vorliegenden Ausführungsbeispiel umfasst die Kältekreislaufregelung zumindest die Komponenten 202, 204, 205, welche zumindest ein Expansionsventils A zur Kältekreislaufregelung mit Spannung versorgen und steuern. Das Funktionsmodul 20 zur Regelung des Expansionsventils weist hierfür eine Spannungserzeugung 205 und einen zugehörigen EMV-Filter zur Spannungsversorgung eines Ventils A des Expansionsventils auf. Ferner umfasst das Funktionsmodul 20 zur Regelung des Expansionsventils eine Kältekreislaufregelung 204, welche mit Sensorik und weiteren Anlagenkomponenten verbunden ist.

Die Figuren 2 und 3 zeigen jeweils eine vorteilhafte Anordnung der Funktionsmodule 20 zu dem Grundmodul 10.

Bei Figur 2 sind die Funktionsmodule 20 mit ihren jeweiligen Trägern 22 parallel zu dem Träger 12 des Grundmoduls 10 ausgerichtet. Die Funktionsmodule werden durch den Distanzhalter 30 in ihrer vorbestimmten Position zueinander gehalten. Zwischen zwei Trägern 12, 22 ist jeweils eine EMV-Abschirmvorrichtung 23 angeordnet, welche bei dem gezeigten Beispiel als den Träger 22 der Funktionsmodule 20 vollständig bedeckende Schicht ausgebildet ist. Die EMV-Abschirmvorrichtung 23 schirmt die Bauelemente 11, 21 des Grundmoduls 10 und der Funktionsmodule 20 jeweils vor elektromagnetischer Störstrahlung ab, welche von den Bauelementen 11, 21 des jeweils anderen Moduls erzeugt werden. Hinzukommt, dass die Funktionsmodule 20 in Abhängigkeit der Höhe ihrer Leistungsaufnahme und dem Maß der von Ihnen erzeugten Störstrahlung angeordnet sind. Das Funktionsmodul 20, dessen Bauelemente 21 im Vergleich mit den Bauelementen 21 der anderen Funktionsmodule 20 die höchste Leistungsaufnahme und somit die höchste Wärmeentwicklung haben sowie die meiste Störstrahlung emittieren, ist räumlich am weitesten von dem Grundmodul 10 beabstandet. Zudem sind die EMV-Abschirmvorrichtungen durch Durchsteckverbinder 31 miteinander verbunden, wodurch sich die Schirmwirkung der miteinander verbundenen EMV-Abschirmvorrichtungen 23 verbessert, wobei die Durchsteckverbinder 31 auch integral mit dem Distanzhalter 30 ausgebildet sein können.

Bei der in Figur 2 gezeigten Anordnung werden die Bauelemente 11,21 des Grundmoduls 10 und der Funktionsmodule 20 vor der Störstrahlung und der Temperatur der anderen Funktionsmodule 20 geschützt. Davon abweichend ist in Figur 3 ein Aufbau dargestellt, bei welchem die Bauelemente 11, 21 des Grundmoduls 10 und der Funktionsmodule 20 von einer von außen wirkenden, nicht durch die Bauelemente 11, 21 des Grundmoduls 10 oder der Funktionsmodule 20 erzeugten Störstrahlung geschützt werden. Das Grundmodul 10 und beispielhaft fünf Funktionsmodule 20 sind quader- bzw. würfelförmig angeordnet, so dass das Grundmodul 10 und jedes der Funktionsmodule eine der sechs Seiten des Würfels bzw. des Quaders bestimmt. Die jeweiligen EMV-Abschirmvorrichtungen 13, 23 sind dabei nach außen gerichtet und die jeweiligen Bauelemente 11, 21 in dem Innenraum des Würfels bzw. Quaders angeordnet, welcher einen Aufnahmeraum 40 für die Bauelemente 11, 21 bildet. Die Bauelemente 11, 21 sind zu jeder Richtung hin von einer EMV-Abschirmvorrichtung 13, 23 umgeben und durch sie geschützt. An der Außenseite bzw. an einer der EMV-Abschirmvorrichtung 13,23 ist zudem ein Kühlelement 24 angeordnet, das kühlend mit dem Aufnahmeraum 40 oder einem der Bauelemente 11, 21 bzw. mehreren der Bauelemente 11, 21 in Kontakt stehen kann. Bei dem vorliegenden Beispiel kann der Distanzhalter 30 als ein Rahmengestell ausgebildet sein, an welchem das Grundmodul 10 und die Funktionsmodule 20 fixiert sind.

Die in Figur 2 dargestellte Anordnung kann mit der Anordnung in Figur 3 kombiniert werden, so dass beispielsweise in dem Aufnahmeraum 40 mehrere Funktionsmodule 20 parallel zu dem Grundmodul 10 angeordnet sind.

## Patentansprüche

1. Steuerungselektronik in modularer Bauweise umfassend ein elektronisches Grundmodul (10) und eine Vielzahl von Funktionsmodulen (20), wobei
das Grundmodul (10) wenigstens eine Zwischenkreisspannung U_{ZK} an einem Spannungsversorgungsausgang zur Spannungsversorgung der Funktionsmodule (20) bereit stellt und
die Funktionsmodule (20) elektrisch und mechanisch mit dem Grundmodul (10) verbunden und von dem Grundmodul (10) mit der Zwischenkreisspannung U_{ZK} versorgt sind, wobei
das Grundmodul (10) und die Funktionsmodule (20) jeweils einen Träger (12, 22) mit elektronischen Bauelementen (11, 21) aufweisen,
die elektronischen Bauelemente (11) des Grundmoduls die Zwischenkreisspannung U_{ZK} erzeugen,
an dem Träger (12) des Grundmoduls (10) zumindest ein Funktionsmodul (20) befestigt ist und
wobei die elektronischen Bauelemente (11, 21) des Grundmoduls (10) und der Funktionsmodule (20) durch eine thermische Entkopplung und/oder eine EMV-Abschirmung voneinander getrennt angeordnet sind,
**dadurch gekennzeichnet, dass**
die elektronischen Bauelemente (11, 21) nach ihrer Funktion in Gruppen getrennt sind,
die Gruppen nach der Höhe ihrer elektronischen Leistungsaufnahme oder Leistungsabgabe bewertet sind
und die Bewertung der Leistungsaufnahme oder Leistungsabgabe eine Zuordnung der Bauelemente (11, 21) zu dem Grundmodul (10) und zu den Funktionsmodulen (20) bestimmt sowie deren relative Position zueinander
und wobei die Bewertung der Leistungsaufnahme oder Leistungsabgabe einen Abstand zwischen den Funktionsmodulen (20) und einen Abstand des jeweiligen Funktionsmoduls (20) zu dem Grundmodul (10) bestimmt.

2. Steuerungselektronik nach dem vorhergehenden Anspruch, wobei
der Träger (22) zumindest eines Funktionsmoduls (20) und/oder der Träger (12) des Grundmoduls (10) jeweils eine Bauelementseite, auf welcher die elektronischen Bauelemente (11, 21) angeordnet sind, und eine Schirmseite aufweisen, auf welcher eine sich über den Träger (12, 22) erstreckende EMV-Abschirmvorrichtung (13, 23) angeordnet ist.

3. Steuerungselektronik nach einem der vorhergehenden Ansprüche, ferner umfassend Durchsteckverbinder (31), wobei
ein Durchsteckverbinder (31) sich von dem Träger (12) des Grundmoduls (10) zu dem Träger (22) eines Funktionsmoduls (20) oder zwischen den Trägern (22) zweier Funktionsmodule (20) erstreckt.

4. Steuerungselektronik nach den vorhergehenden Ansprüchen 2 und 3, wobei
der Durchsteckverbinder (31) die EMV-Abschirmvorrichtung (13) des Grundmoduls (10) mit der EMV-Abschirmvorrichtung (23) des Funktionsmoduls (20) oder die EMV-Abschirmvorrichtungen (23) der Funktionsmodule (20) miteinander elektrisch verbindet.

5. Steuerungselektronik nach einem der vorhergehenden Ansprüche 1 bis 4, wobei
wenigstens eine der EMV-Abschirmvorrichtungen (13, 23) mit einem vorbestimmten Potential verbunden ist.

6. Steuerungselektronik nach einem der vorhergehenden Ansprüche, wobei
die Träger (22) der Funktionsmodule (20) und der Träger (12) des Grundmoduls (10) in einer vorbestimmten Anordnung zueinander parallel und jeweils zueinander beabstandet angeordnet sind.

7. Steuerungselektronik nach einem der vorhergehenden Ansprüche 2 bis 6, wobei
zwischen den elektronischen Bauelementen (11, 21) des Grundmoduls (10) und den elektronischen Bauelementen eines Funktionsmoduls (20) und/oder zwischen den elektronischen Bauelementen zweier Funktionsmodule (20) jeweils eine der jeweiligen EMV-Abschirmvorrichtungen angeordnet ist.

8. Steuerungselektronik nach einem der vorhergehenden Ansprüche, wobei
die Träger (22) der Funktionsmodule (20) und der Träger (12) des Grundmoduls (10) in einer vorbestimmten Anordnung einen Aufnahmeraum (40) zwischen sich bestimmen, der zu jeder Seite durch die Träger (22) der Funktionsmodule (20) und den Träger (12) des Grundmoduls (10) begrenzt ist und
die elektronischen Bauelemente (11) des Grundmoduls (10) und die elektronischen Bauelemente (21) der Funktionsmodule (20) in dem Aufnahmeraum (40) angeordnet sind.

9. Steuerungselektronik nach einem der vorhergehenden Ansprüche 5 bis 8, ferner umfassend einen Distanzhalter (30), wobei
der Träger (12) des Grundmoduls und die Träger (22) der Funktionsmodule (20) an dem Distanzhalter (30) fixiert sind und durch den Distanzhalter (30) in ihrer vorbestimmten Anordnung zueinander gehalten werden.

10. Steuerungselektronik nach einem der vorhergehenden Ansprüche, wobei
das Grundmodul (10) integral mit einem Funktionsmodul (20) gemeinsam auf dem Träger (12) des Grundmoduls (10) ausgebildet ist.

11. Steuerungselektronik nach einem der vorhergehenden Ansprüche, wobei
zumindest zwei Funktionsmodule (20) integral miteinander auf einem gemeinsamen Träger (22) ausgebildet sind.

12. Steuerungselektronik nach einem der vorhergehenden Ansprüche, wobei
zumindest ein Teil der Funktionsmodule (20) als elektronische Bauelemente (21) eine Kommutierungseinheit (201) zur Kommutierung der Zwischenkreisspannung U_{ZK} und einen EMV-Filter (202) umfasst, der ausgebildet ist, die kommutierte Spannung zu filtern.

13. Steuerungselektronik nach einem der vorhergehenden Ansprüche, wobei
an dem Träger (12) des Grundmoduls (10) und/oder an den Trägern (22) der Funktionsmodule (20) Kühlelemente (24) angeordnet sind.

## Claims

1. A control electronics in modular design, comprising an electronic base module (10) and a plurality of functional modules (20), wherein
the base module (10) provides at least one DC link voltage U_{ZK} at a voltage supply output for supplying voltage to the functional modules (20), and
the functional modules (20) are electrically and mechanically connected to the base module (10) and supplied with the DC link voltage U_{ZK} from the base module (10), wherein
the base module (10) and the functional modules (20) each have a carrier (12, 22) with electronic components (11, 21),
the electronic components (11) of the base module produce the intermediate circuit voltage U_{ZK},
at least one functional module (20) is attached to the carrier (12) of the base module (10), and
wherein the electronic components (11, 21) of the base module (10) and of the functional modules (20) are arranged separated from each other by means of thermal decoupling and/or EMC shield,
**characterized in that**
the electronic components (11, 21) are separated into groups according to their function,
the groups are evaluated according to their electronic power input or power output, and
the evaluation of the power input or power output determines an allocation of the components (11, 21) to the base module (10) and to the functional modules (20) as well as their relative position to each other,
and wherein the evaluation of the power input or power output determines a distance between the functional modules (20) and a distance of the respective functional module (20) to the base module (10).

2. The control electronics according to the preceding claim, wherein
the carrier (22) of at least one functional module (20) and/or the carrier (12) of the base module (10) each have a component side on which the electronic components (11, 21) are arranged, and a shielding side on which an EMC shielding device (13, 23) extending over the carrier (12, 22) is arranged.

3. The control electronics according to any of the preceding claims, further comprising through-connectors (31), wherein
a through-connector (31) extends from the carrier (12) of the base module (10) to the carrier (22) of a functional module (20) or between the carriers (22) of two functional modules (20).

4. The control electronics according to the preceding claims 2 and 3, wherein
the through-connector (31) electrically connects the EMC shielding device (13) of the base module (10) to the EMC shielding device (23) of the functional module (20) or the EMC shielding devices (23) of the functional modules (20) to each other.

5. The control electronics according to any of the preceding claims 1 to 4, wherein
at least one of the EMC shielding devices (13, 23) is connected to a predetermined potential.

6. The control electronics according to any of the preceding claims, wherein
the carriers (22) of the functional modules (20) and the carrier (12) of the base module (10) are arranged in a predetermined arrangement parallel to one another and each spaced apart from one another.

7. The control electronics according to any of the preceding claims 2 to 6, wherein
between the electronic components (11, 21) of the base module (10) and the electronic components of a functional module (20) and/or between the electronic components of two functional modules (20), one of the respective EMC shielding devices is arranged.

8. The control electronics according to any of the preceding claims, wherein
the carriers (22) of the functional modules (20) and the carrier (12) of the base module (10) define, in a predetermined arrangement, a receiving space (40) between them which is bounded on each side by the carriers (22) of the functional modules (20) and the carrier (12) of the base module (10), and
the electronic components (11) of the base module (10) and the electronic components (21) of the functional modules (20) are arranged in the receiving space (40).

9. The control electronics according to any of the preceding claims 5 to 8, further comprising a spacer (30), wherein
the carrier (12) of the base module and the carriers (22) of the functional modules (20) are fixed to the spacer (30) and are held in their predetermined arrangement relative to one another by the spacer (30).

10. The control electronics according to any of the preceding claims, wherein
the base module (10) is formed integrally with a functional module (20) together on the carrier (12) of the base module (10).

11. The control electronics according to any of the preceding claims, wherein
at least two functional modules (20) are formed integrally with each other on a common carrier (22).

12. The control electronics according to any of the preceding claims, wherein
at least some of the functional modules (20) comprise as electronic components (21) a commutation unit (201) for commutation of the DC link voltage U_{ZK} and an EMC filter (202) which is designed to filter the commutated voltage.

13. The control electronics according to any of the preceding claims, wherein cooling elements (24) are arranged on the carrier (12) of the base module (10) and/or on the carriers (22) of the functional modules (20).

## Revendications

1. Electronique de commande de conception modulaire, comprenant un module de base électronique (10) et une pluralité de modules fonctionnels (20), dans laquelle
le module de base (10) fournit au moins une tension de circuit intermédiaire U_{ZK} au niveau d'une sortie d'alimentation en tension pour l'alimentation en tension des modules fonctionnels (20), et
les modules fonctionnels (20) sont reliés électriquement et mécaniquement au module de base (10) et alimentés par le module de base (10) en tension de circuit intermédiaire U_{ZK}, dans laquelle
le module de base (10) et les modules fonctionnels (20) présentent respectivement un support (12, 22) pourvu de composants électroniques (11, 21),
les composants électroniques (11) du module de base produisent la tension de circuit intermédiaire U_{ZK},
au moins un module fonctionnel (20) est fixé au support (12) du module de base (10), et
dans laquelle les composants électroniques (11, 21) du module de base (10) et des modules fonctionnels (20) sont séparés les uns des autres par un découplage thermique et/ou un blindage CEM,
**caractérisée en ce que**
les composants électroniques (11, 21) sont divisés en groupes selon leur fonction,
les groupes sont évalués selon le niveau de leur puissance électronique absorbée ou débitée,
et l'évaluation de la puissance absorbée ou de la puissance débitée détermine une attribution des composants (11, 21) au module de base (10) et aux modules fonctionnels (20), ainsi que leur position relative les uns par rapport aux autres,
et dans laquelle l'évaluation de la puissance absorbée ou de la puissance débitée détermine une distance entre les modules fonctionnels (20) et une distance du module fonctionnel (20) respectif au module de base (10).

2. Electronique de commande selon la revendication précédente, dans laquelle le support (22) d'au moins un module fonctionnel (20) et/ou le support (12) du module de base (10) présentent respectivement une face de composant sur laquelle sont disposés les composants électroniques (11, 21), et une face de blindage sur laquelle est disposé un dispositif de blindage CEM (13, 23) s'étendant sur le support (12, 22).

3. Electronique de commande selon l'une quelconque des revendications précédentes, comprenant en outre un connecteur traversant (31), dans laquelle un connecteur traversant (31) s'étend du support (12) du module de base (10) au support (22) d'un module fonctionnel (20) ou entre les supports (22) de deux modules fonctionnels (20).

4. Electronique de commande selon les revendications précédentes 2 et 3, dans laquelle le connecteur traversant (31) relie électriquement le dispositif de blindage CEM (13) du module de base (10) au dispositif de blindage CEM (23) du module fonctionnel (20) ou les dispositifs de blindage CEM (23) des modules fonctionnels (20) les uns aux autres.

5. Electronique de commande selon l'une quelconque des revendications précédentes 1 à 4, dans laquelle au moins l'un des dispositifs de blindage CEM (13, 23) est relié à un potentiel prédéterminé.

6. Electronique de commande selon l'une quelconque des revendications précédentes, dans laquelle le support (22) des modules fonctionnels (20) et le support (12) du module de base (10) sont disposés en parallèle les uns par rapport aux autres et respectivement à distance les uns des autres dans une disposition prédéterminée.

7. Electronique de commande selon l'une quelconque des revendications précédentes 2 à 6, dans laquelle respectivement l'un des dispositifs de blindage CEM respectifs est disposé entre les composants électroniques (11, 21) du module de base (10) et les composants électroniques d'un module fonctionnel (20) et/ou entre les composants électroniques de deux modules fonctionnels (20).

8. Electronique de commande selon l'une quelconque des revendications précédentes, dans laquelle
les supports (22) des modules fonctionnels (20) et le support (12) du module de base (10) déterminent entre eux dans une disposition prédéterminée un espace de réception (40) qui est délimité de chaque côté par les supports (22) des modules fonctionnels (20) et le support (12) du module de base (10), et
les composants électroniques (11) du module de base (10) et les composants électroniques (21) des modules fonctionnels (20) sont disposés dans l'espace de réception (40).

9. Electronique de commande selon l'une quelconque des revendications précédentes 5 à 8, comprenant en outre un élément d'écartement (30), dans laquelle le support (12) du module de base et les supports (22) des modules fonctionnels (20) sont fixés à l'élément d'écartement (30) et sont maintenus par l'élément d'écartement (30) dans leur disposition prédéterminée les uns par rapport aux autres.

10. Electronique de commande selon l'une quelconque des revendications précédentes, dans laquelle le module de base (10) est réalisé d'un seul tenant avec un module fonctionnel (20) conjointement sur le support (12) du module de base (10).

11. Electronique de commande selon l'une quelconque des revendications précédentes, dans laquelle au moins deux modules fonctionnels (20) sont réalisés d'un seul tenant l'un avec l'autre sur un support (22) commun.

12. Electronique de commande selon l'une quelconque des revendications précédentes, dans laquelle au moins une partie des modules fonctionnels (20) comprend comme composants électroniques (21) une unité de commutation (201) pour commuter la tension de circuit intermédiaire U_{ZK} et un filtre CEM (202) qui est réalisé pour filtrer la tension commutée.

13. Electronique de commande selon l'une quelconque des revendications précédentes, dans laquelle des éléments de refroidissement (24) sont disposés sur le support (12) du module de base (10) et/ou sur les supports (22) des modules fonctionnels (20).
